# EUROPEAN PATENT APPLICATION

(11) **EP 0 755 962 A2**
(43) Date of publication of application: **29.01.1997**
(21) Application number: 96111577.1
(22) Date of filing: 18.07.1996
(51) Int. Cl.: C08G 77/452, C08G 73/10

(54) **Photosensitive polyimidosiloxanes and compositions and insulating films made thereof**

(30) Priority: 28.07.1995 JP 192794/95; 11.06.1996 JP 149050/96
(71) Applicant: UBE INDUSTRIES, LTD., Ube-shi, Yamaguchi-ken 755 (JP)
(72) Inventor: Ishikawa, Seiji, c/o Polymer Res. Lab., Ichihara-shi, Chiba 290 (JP); Yasuno, Hiroshi, c/o Polymer Res. Lab., Ichihara-shi, Chiba 290 (JP); Sakurai, Hiroyuki, c/o Polymer Res. Lab., Ichihara-shi, Chiba 290 (JP)
(74) Representative: Hoeger, Stellrecht & Partner

(57) **Abstract**

A photosensitive polyimidosiloxane obtained by polymerization and chemical imidation of an aromatic tetracarboxylic dianhydride having two benzene rings bonded either directly or via CO or O, and an aromatic diamine with a photosensitive group and a diamine which includes diaminopolysiloxane. It may be used to form films with large thicknesses and excellent photocuring properties and solubility in organic solvents, while high-temperature heat treatment thereof is unnecessary and the electrical and mechanical characteristics of its cured films are satisfactory.

## Description

### BACKGROUND OF THE INVENTION

### 1. Field of the Invention

The present invention relates to novel aromatic polyimidosiloxanes with excellent solubility in organic solvents and containing photosensitive groups in their main polymer chains. More specifically, the present invention relates to organic solvent-soluble photosensitive polyimidosiloxanes with excellent heat resistance, electrical properties and mechanical properties including flexibility, which are suitable as overcoat materials for flexible wiring boards, interlayer insulating materials, or materials for forming insulating films on solid elements and passivation films for industrial semiconductors.

### 2. Description of the Related Art

Overcoat materials for flexible wiring boards, interlayer insulating films for multilayer boards, materials for forming insulating films on solid elements and passivation films for industrial semiconductors, as well as interlayer insulating materials for semiconductor integrated circuits and multilayer printed wiring boards, require excellent heat resistance and insulating properties, and photosensitive heat resistant materials are being sought to meet the demand for high density and high integration.

A number of ideas have been devised for forming such insulating films of polyimides, due to their high heat resistance and insulating properties.

However, commonly used polyimides are either insoluble in solvents and have no photosensitive groups, or the polymers containing photosensitive groups are all in the form of polyimide precursors, i.e. polyamic acids, modified by amidation or esterification of the carboxylic acid, and must have the polyamic acids converted into polyimides during photocuring, or be post-baked into polyimides after photocuring.

There also exist heat-resistant photoresist compositions prepared by mixing organic solvent-soluble polyimides (without photosensitive groups) with monomers which contain a photocurable group and subjecting the mixture to photocuring (see, for example, Japanese Unexamined Patent Publication No. 54-109828), but such compositions have inferior photocuring properties, while the heat resistance of the polyimides after photocuring is insufficient. In addition, since aromatic polyimides with superior heat resistance generally have inferior solubility in solvents, they are not suitable for the formation of relief patterns which involves a step of dissolving the unexposed parts after photocuring.

Ideas have also been proposed for obtaining polyimides with excellent photosensitivity and heat resistance by reacting a tetracarboxylic dianhyride with a diamine compound containing a photocrosslinkable unsaturated double bond, such as diaminochalcone (see, for example, Japanese Unexamined Patent Publication No. 57-131227).

However, although polyimides obtained in this manner have excellent photosensitivity, their inferior solubility in organic solvents results in longer times required for dissolution, thus constituting a practicality problem for the formation of relief patterns.

Polyimidosiloxanes have also been proposed in order to obtain flexible photosensitive polyimides (Japanese Unexamined Patent Publication Nos. 2-50161, 4-252227), but since polyamic acids are used as the polymer components, high-temperature heating is necessary after patterning to accomplish imidation, thus constituting a practicality problem in that thermal damage can occur in the board.

### SUMMARY OF THE INVENTION

It is an object of the present invention to provide a photosensitive polyimide with excellent solubility in organic solvents, high sensitivity to photocuring, and high heat resistance when photocured.

It is another object of the invention to provide a photosensitive solution composition having substantially no practicality problems.

It is yet another object of the invention to provide an electrical insulating film with satisfactory resolving power, which can be formed to a large thickness and requires no high-temperature heating (250-400°C) for imidation after patterning.

The present invention provides organic solvent-soluble photosensitive polyimidosiloxanes which are prepared by polymerization and imidation of substantially equimolar amounts of:
an aromatic tetracarboxylic dianhyride component represented by the following general formula (1)

R₁-X-R₂ (1)

wherein R₁ and R₂ each represent mononuclear aromatic residues with acid anhydride groups and X represents CO, O or a direct bond,
and a diamine component consisting of 15-80 mole percent of an aromatic diamine compound containing a photosensitive group, represented by the following general formula (2)

H₂N-R₃-NH₂ (2)

wherein R₃ represents an aromatic residue containing a photosensitive group with an unsaturated hydrocarbon group, and 85-20 mole percent of a diaminopolysiloxane represented by the following general formula (3) 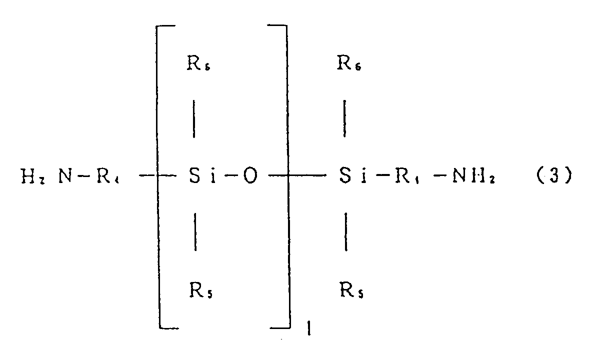 wherein R₄ represents a divalent hydrocarbon residue, R₅ independently represents an alkyl group of 1-3 carbon atoms or a phenyl group, and l represents an integer of 3-30.

The present invention further provides photosensitive polyimidosiloxane solution compositions prepared by dissolving in an organic solvent an organic solvent-soluble photosensitive polyimidosiloxane prepared by polymerization and imidation of substantially equimolar amounts of:
an aromatic tetracarboxylic dianhyride component represented by the following general formula (1)

R₁-X-R₂ (1)

wherein R₁ and R₂ each represent mononuclear aromatic residues with acid anhydride groups and X represents CO, O or a direct bond,
and a diamine component consisting of 15-80 mole percent of an aromatic diamine compound containing a photosensitive group, represented by the following general formula (2)

H₂N-R₃-NH₂ (2)

wherein R₃ represents an aromatic residue containing a photosensitive group with an unsaturated hydrocarbon group, and 85-20 mole percent of a diaminopolysiloxane represented by the following general formula (3) 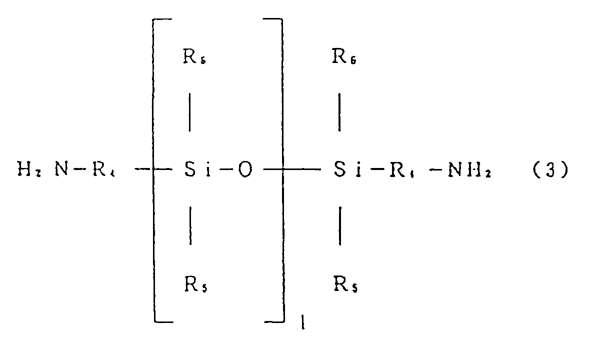 wherein R₄ represents a divalent hydrocarbon residue, R₅ independently represents an alkyl group of 1-3 carbon atoms or a phenyl group, and l represents an integer of 3-30,
wherein the solid concentration of the polyimidosiloxane is 20 to 50 wt%.

The present invention further provides an insulating film having a polyimidosiloxane as the polymer component, having a thickness of 2-50 µm, and having a resolving power of at least 10 µm after photocuring by irradiation with a superhigh-pressure mercury lamp (2 kW) on a dried film prepared from a solution of the photosensitive polyimidosiloxane composition.

The present invention further provides an insulating film characterized in that a photocured photosensitive polyimidosiloxane solution composition is used to form the insulating film on a board-mounted circuit, the thickness thereof is 2-50 µm, the resolving power is at least 10 µm, and the soldering heat resistance is 250-300°C.

### DESCRIPTION OF THE PREFERRED EMBODIMENTS

The polyimidosiloxanes of the present invention may be produced by random or block polymerization of substantially equimolar amounts of an aromatic tetracarboxylic dianhydride and two types of diamine components, represented by the general formulas given above, in an organic solvent, followed by chemical imidation of the resulting polyamic acid.

The aromatic tetracarboxylic dianhydride represented by general formula (1) above according to the invention may be a biphenyltetracarboxylic dianhydride, benzophenonetetracarboxylic dianhydride or oxydiphthalic anhydride, preferred among which are 3,3',4,4'-benzophenonetetracarboxylic dianhydride and 2,3,3',4'-biphenyltetracarboxylic dianhydride (a-BPDA).

The photosensitive group-containing aromatic diamine represented by general formula (2) above according to the invention may be any aromatic diamine with a photosensitive unsaturated hydrocarbon group, examples of which include unsaturated benzoic acid esters such as 3,5-diaminobenzoic ethylacrylic acid ester, 2,4-diaminobenzoic ethylacrylic acid ester, 3,5-diaminobenzoic ethylmethacrylic acid ester, 2,4-diaminobenzoic ethylmethacrylic acid ester, 3,5-diaminobenzoic glycidylacrylate ester, 2,4-diaminobenzoic glycidylacrylate ester, 3,5-diaminobenzoic glycidylmethacrylate ester, 2,4-diaminobenzoic glycidylmethacrylate ester, 3,5-diaminobenzoic cinnamyl ester and 2,4-diaminobenzoic cinnamyl ester; benzyl (meth)acrylates such as 3,5-diaminobenzyl acrylate and 3,5-diaminobenzyl methacrylate; unsaturated diphenylether esters such as 4-acrylamido-3,4'-diaminodiphenyl ether, 2-acrylamido-3,4'-diaminodiphenyl ether, 2-acrylamido-3,4'-diaminodiphenyl ether, 4-cinnamamido-3,4'-diaminodiphenyl ether, 3,4'-diacrylamido-3',4-diaminodiphenyl ether, 3,4'-dicinnamamido-3',4-diaminodiphenyl ether, 4-methyl-2'-carboxyethylmethacrylic acid ester-3,4'-diaminodiphenyl ether [carboxyethylmethacrylic acid ester: CH₂=C(CH₃)COOCH₂CH₂OOC-], and 4-methyl-2'-carboxyethylacrylic acid ester-3,4'-diaminodiphenyl ether [carboxyethylacrylic acid ester: CH₂=CHCOOCH₂CH₂OOC-]; and substituted or unsubstituted diaminochalcones such as 4,4'-diaminochalcone, 3,3'-diaminochalcone, 3,4'-diaminochalcone, 3',4-diaminochalcone, 4'-methyl-3',4-diaminochalcone, 4'-methoxy-3',4-diaminochalcone and 3'-methyl-3,5-diaminochalcone.

A single photosensitive group-containing aromatic diamine represented by general formula (2) above may be used, or 2 or more thereof may be used in combination.

The diaminopolysiloxane represented by general formula (3) above according to the invention preferably is one wherein R₄ in general formula (3) is a divalent hydrocarbon residue, preferably a "polymethylene" group of 2-6 carbon atoms, particularly 3-5 carbon atoms, or a phenylene group, R₅ is independently an alkyl group of 1-3 carbon atoms such as a methyl, ethyl, propyl or a phenyl group, and l is 3-30, especially 5-20. So long as l is in the aforementioned range (3-30), the diaminopolysiloxane represented by general formula (3) may be a homogeneous compound, or it may be a mixture of compounds with different values for l. In the case of a mixture, the average value for l is preferably in the range of 5-20, as calculated based on amino equivalents.

According to the present invention it is necessary for the diamine components to be a photosensitive group-containing aromatic diamine represented by general formula (2) above and a diaminopolysiloxane represented by general formula (3) above, with the aromatic diamine represented by general formula (2) to be used in a proportion of 15-80 mole percent, preferably 20-70 mole percent, and the diaminopolysiloxane represented by general formula (3) in a proportion of 85-20 mole percent, preferably 80-30 mole percent.

If the proportion of the photosensitive group-containing aromatic diamine represented by general formula (2) is less than the minimum given above, then the photosensitivity of the resulting photosensitive polyimidosiloxane is reduced, a high resolving power electrical insulating film cannot be obtained after photocuring, and the thermal decomposition temperature of the photosensitive polyimidosiloxane is lowered. If the proportion of the photosensitive group-containing aromatic diamine represented by general formula (2) is greater than the maximum given above, then the organic solubility of the resulting photosensitive polyimidosiloxane is reduced.

Other aromatic diamines may also be used in addition to the diamines represented by general formulas (2) and (3). These are preferably used at not more than 65 mole percent, more preferably not more than 30 mole percent of the diamine component. Other suitable aromatic diamines include, for example, aromatic diamines with two benzene rings such as 4,4'-diaminodiphenyl ether, 4,4'-diaminodiphenylmethane, 4,4'-diaminodiphenylsulfone and o-tolidine; aromatic diamines with 3 benzene rings such as 1,4-bis(4-aminophenoxy)benzene and 1,4-bis(4-aminophenyl)benzene; and aromatic diamines with 4 benzene rings such as bis[4-(4-aminophenoxy)phenyl]sulfone and 2,2-bis[4-(4-aminophenoxy)phenyl]propane.

The photosensitive polyimidosiloxane of the invention is preferably obtained by first subjecting an aromatic tetracarboxylic dianhyride component and a substantially equimolar amount of a diamine component to a random or block polymerization reaction, preferably a random polymerization reaction, for about 1-48 hours in an organic solvent at a reaction temperature of 100°C or lower, preferably at a reaction temperature of 10-80°C, and then diluting the polyamic acid solution resulting from the polymerization reaction with an organic solvent, and adding a chemical imidating agent, for example a carboxylic anhydride such as acetic anhydride or a tertiary amine such as pyridine, at a temperature of 100°C or lower, preferably at a reaction temperature of 10-50°C, for imidation reaction for about 0.1 to 5 hours.

The organic solvent used for the above-mentioned polymerization reaction and imidation reaction may be, for example, N,N-dimethylsulfoxide, N,N-dimethylformamide, N,N-diethylformamide, N,N-dimethylacetoamide, N,N-diethylacetoamide, N-methyl-2-pyrrolidone (NMP) or hexamethylenephosphoamide.

The photosensitive polyimidosiloxane of the invention may be used without modification, or depending on the use, for example when used as a pattern-forming material, it is preferably used as a solution in an organic solvent.

The aforementioned organic solvent may be a sulfoxide-based solvent such as dimethylsulfoxide or diethylsulfoxide, a formamide-based solvent such as N,N-dimethylformamide or N,N-diethylformamide, an acetoamide-based solvent such as N,N-dimethylacetoamide or N,N-diethylacetoamide, a pyrrolidone-based solvent such as N-methyl-2-pyrrolidone, N-ethyl-2-pyrrolidone or N-vinyl-2-pyrrolidone, a glyme-based solvent such as methyldiglyme or methyltriglyme, or hexamethylphosphoric triamide, γ-butyllactone or cyclohexanone.

The polymer solid concentration in the solution composition of the photosensitive polyimidosiloxane of the invention is preferably 20-50 wt%.

A sensibilizer and photopolymerization initiator are preferably also added to the above-mentioned photosensitive polyimidosiloxane solution.

A photopolymerizable compound with an ethylenic unsaturated group may also be added within a range which does not impair the properties of the insulating film after photocuring.

The aforementioned sensibilizer or photopolymerization initiator may be Michler's ketone, benzoin, benzoin methyl ether, benzoin ethyl ether, benzoin isopropyl ether, 2-t-butylanthraquinone, 1,2-benzo-9,10-anthraquinone, 4,4'-bis(diethylamino)benzophenone, acetophenone, benzophenone, thioxanthone, 1,5-acenaphthene, 1-hydroxy-cyclohexylphenyl ketone, 2-benzyl-1,2-dimethylamino-1-(4-morpholinophenyl)butane-1,1-hydroxy-cyclohexylphenyl ketone, etc., and these are preferably added in a total of 1-50 parts by weight, and especially 10-50 parts by weight, with respect to 100 parts by weight of the polyimidosiloxane.

The above-mentioned photopolymerizable compound having an ethylenic unsaturated group may be ethyleneglycol di(meth)acrylate, propyleneglycol di(meth)acrylate, trimethylolpropane tri(meth)acrylate, tetramethylolmethane tetra(meth)acrylate, N,N'-methylene bis(meth)acrylate, diethylaminoethyl (meth)acrylate, 1,3,5-triacryloylhexahydro-s-triazine or tris(hydroxyethylacryloyl) isocyanate.

The solution composition of the photosensitive polyimidosiloxane of the invention may also contain Aerosil (preferably used in an amount of 10-50 parts by weight to 100 parts by weight of the photosensitive polyimidosiloxane), a finely divided inorganic filler such as Wallastonite, silica or talc (preferably used in an amount of 10-100 parts by weight to 100 parts by weight of the photosensitive polyimidosiloxane), a finely divided polymer filler or a finely divided or soluble inorganic or organic dye.

A pattern may be formed by using the photosensitive polyimidosiloxane of the invention in the form of a photosensitive polyimidosiloxane solution composition as mentioned above.

For example, the above-mentioned photosensitive polyimidosiloxane solution may be first applied onto a board and then dried to remove the organic solvent. The application onto the board may be accomplished by screen printing, a curtain roll, a reverse roll, or the like. The applied film (preferably with a thickness of 5-100 µm, and especially 10-100 µm) is dried at 90°C or lower, and preferably 48-80°C. After drying, a negative photomask is placed on the dried applied film which is then irradiated with activating light rays such as ultraviolet rays, visible light rays or electron rays. A polyimidosiloxane pattern may then be obtained by washing the unexposed portions with a developing agent using a shower or ultrasonic waves. The thickness of the cured film is preferably about 2-50 µm.

The developing agent may be an organic solvent such as N,N-dimethylformamide, N,N-dimethylacetoamide, dimethylsulfoxide, N-methyl-2-pyrrolidone, hexamethylenephosphoamide, diglyme, triglyme, or a mixture thereof with methanol, ethanol or the like.

The photosensitive polyimidosiloxane of the invention is very readily soluble, and thus the polyimidosiloxane in the unexposed portions is easily removed to allow ready formation of a pattern.

Many other excellent effects are provided, in that since the photosensitive polyimidosiloxane and solution composition of the invention have high photosensitivity and excellent light transmittance and photocrosslinkability, there is no need for a separate resist for image formation as with non-photosensitive polyimides of the prior art, and since there is no need for high-temperature heating (250-400°C) for imidation after image formation as with photosensitive polyamic acids, an after-heating step at 150-200°C being sufficient, not only are high reliability and lower cost afforded, but thermal damage to the boards is also avoided. The photosensitive polyimidosiloxane composition of the invention may therefore be suitably used for the formation of both negative patterns and positive patterns.

Furthermore, patterns made with cured films formed from photosensitive polyimidosiloxanes of the invention or their solution compositions have excellent heat resistance and electrical and mechanical properties, and especially excellent flexibility. For example, an insulating film according to the invention, suitably with a thickness of about 2-50 µm, has a post-photocuring resolving power of at least 10 µm, and usually about 10-1000 µm. Thus, the insulating film according to the invention is particularly suited as an insulating material for high-density flexible boards.

Examples of the present invention will now be provided.

Evaluation of the following examples was conducted in the following manner.

### (Property tests)

### 1. Inherent viscosity

The inherent viscosity (In η/c) was measured at 30°C in a solution containing 0.5g of a polymer in 100 ml of N-methyl-2-pyrrolidone.

### 2. Polyimidosiloxane film formability

A solution of 20g polyimidosiloxane dissolved in 100 ml N-methyl-2-pyrrolidone was applied onto a Teflon plate (1.0 mm) to a polyimidosiloxane film thickness of approximately 20 µm and dried at 70°C for 30 minutes, and the occurrence of cracks upon heating at 160°C for 60 minutes and 180° bending was observed. Absence of cracking was indicated by "○", and cracking was indicated by "x".

### 3. Solubility of polyimidosiloxane in NMP

A 0.2g portion of polyimidosiloxane was added to 0.8g of N-methyl-2-pyrrolidone, and the state of dissolution of the polyimidosiloxane was observed, indicating dissolution for up to 1 hour by "*", dissolution for up to one day by "○", swelling alone by "△", and no dissolution by "x".

### 4. Thermal decomposition temperature

This was measured using a thermogravimetric analyzer.

### 5. Evaluation of photocuring property

A dam was constructed using a polyimide film as the spacer, a bar coater was used for uniform casting of ink on copper foil (35 µm), and the dried film obtained from drying at 70°C for 30 minutes was subjected to the photosensitivity and resolving power tests described below.

### Photosensitivity

The dried film was irradiated using a superhigh-pressure mercury lamp (2 kW) at an illuminance of 7 mW/cm², and the amount of light irradiation required for photocuring was recorded.

### Resolving power

A negative film (a test pattern containing an equally-spaced figure pattern having a line width and spacing of 0.075-2.0 mm) was placed on the dried film, and a superhigh-pressure mercury lamp (2 kW) was used to produce a prescribed degree of irradiation for photocuring, after which it was immersed in a triglyme solvent and the uncured portions were washed off, the surface was washed with methanol to obtain a relief pattern adhering to the polyimide film which was then heat treated at 160°C for 120 minutes, and the resolving power of the pattern was measured.

### 6. Measurement of mechanical properties

The photosensitive polyimidosiloxane solution composition was Teflon-coated and dried at 70°C for 30 minutes, and after subsequent 1 J/cm² ultraviolet light exposure and heating at 200°C for one hour, the film was peeled off, a dumbbell-shaped test piece was cut out, and a tension tester was used for measurement according to ASTM D882 to determine the tensile strength, elongation rate and initial elastic modulus.

### 7. Electrical properties

The photosensitive polyimidosiloxane solution composition was applied onto a 0.3 mm-thick copper plate and dried at 70°C for 30 minutes, and the sample obtained by subsequent 1 J/cm² ultraviolet light exposure and heating at 200°C for one hour was subjected to testing based on JIS C 2103 (electrical insulation varnish test method).

### Example 1

### (Amic acid synthesis step)

After addition of 25.06g (0.085 mol) of 2,3,3',4'-biphenyltetracarboxylic dianhydride (a-BPDA) and 108g NMP to a 1 liter-volume reactor equipped with a dropping funnel and a nitrogen admission tube, and thorough dissolution, 1.2g of hydroquinone and 1.2g of 4-methoxyhydroquinone were added as anti-gelating agents. The solution was cooled with dry ice/methanol (-30°C) while circulating drying air, after which 6.0g (0.023 mol) of 3,5-dimethylbenzoic ethylmethacrylic acid ester [melting point: 88-89°C, elemental analysis (found, %): C: 59.36, H: 6.08, N: 10.49] and 54.0g (0.062 mol) diaminopolysiloxane [R₄ being propyl, R₅ being methyl and l being 10 in general formula (3); amino equivalents: 435] were added over 3 to 5 minutes. The equipment was washed in the apparatus with 40g NMP. External cooling was followed by stirring at 25-28°C for 20-30 minutes to obtain a polyamic acid solution.

### (Chemical imidation step)

A 472g portion of NMP was then added to the same reactor to dilute the reaction solution. Next, 145.2g acetic anhydride and 62.2g pyridine were added with the dropping funnel over 10 minutes at 25-28°C while externally cooling, and the mixture was stirred overnight at 18-22°C to obtain the imidated solution.

### (Precipitation/filtration/washing/drying step)

The above-mentioned imidated solution was precipitated using a disperser for 2 minutes in a 3-liter container containing 1.5 liters of methanol.

The precipitate was filtered out using filter paper (No.3, product of Advantech) and washed with a small amount of methanol. This procedure was repeated 3 times, after which the filtrated solid was vacuum-dried (25°C, 15 minutes) to obtain 85.5g of a photosensitive polyimidosiloxane.

### (Inking step)

After dissolving 30g of the above-mentioned photosensitive group-containing polyimidosiloxane in 45g NMP, 5.25g of Aerosil (average particle size: approx. 0.02 µm), 12g of talc (average particle size: 1.5 µm), 6.92g of 1-hydroxy-cyclohexylphenyl ketone and 6.92g of 2-benzyl-1,2-dimethylamino-1-(4-morpholinophenyl)butane-1 were added thereto and mixed. The mixture was kneaded with a triple roller to obtain an ink/photosensitive polyimidosiloxane solution composition.

The results from evaluation of the photosensitive polyimidosiloxane solution composition are summarized in Table 2.

Measurement of the mechanical properties of the exposed and heat-treated film revealed a tensile strength of 0.93 kg/mm², an elongation of 9% and an initial elastic modulus of 33 kg/mm².

Measurement of the electrical properties of the exposed and heat-treated film revealed a volume resistance value of 9.2 × 10¹⁴ Ω·cm.

When the soldering heat resistance of the insulating film was evaluated by conventional methods, no problems were found up to 300°C.

### Example 2

A photosensitive polyimidosiloxane was obtained in the same manner as Example 1, except that benzophenonetetracarboxylic dianhydride (BTDA) was used instead of 2,3,3',4'-biphenyltetracarboxylic dianhydride.

A photosensitive polyimidosiloxane solution composition (ink) was then obtained in the same manner as described in Example 1.

When the soldering heat resistance of the photocured photosensitive polyimidosiloxane (insulating film) was evaluated by conventional methods, no problems were found up to 300°C.

The results of evaluation of the other properties are summarized in Tables 1 and 2.

### Examples 3-5

Photosensitive polyimidosiloxanes were obtained in the same manner as Example 1, except that the photosensitive group-containing aromatic diamines listed in Table 1 were used instead of the 3,5-diaminobenzoic ethylmethacrylic acid ester of Example 1.

Photosensitive polyimidosiloxane solution compositions (inks) were then obtained in the same manner as described in Example 1.

The soldering heat resistance of the insulating films obtained from the photosensitive polyimidosiloxane solutions were evaluated by conventional methods. No problems were found in any of these up to 300°C.

The results of evaluation of the other properties are summarized in Tables 1 and 2.

### Comparative Example 1

A photosensitive polyimidosiloxane was obtained in the same manner as Example 1, except that no diaminosiloxane was used. The resulting photosensitive polyimidosiloxane was insoluble in N-methylpyrrolidone, and thus measurement of the photocuring properties could not be made.

### Comparative Example 2

A photosensitive polyimidosiloxane was obtained in the same manner as Example 1, except that pyromellitic dianhydride was used instead of 2,3,3',4'-biphenyltetracarboxylic dianhydride (PMDA).

The resulting photosensitive polyimidosiloxane merely swelled in N-methylpyrrolidone, making it impossible to obtain an ink solution and measure the photocuring properties.

### Comparative Example 3

### Production of base polymer

A polyimidosiloxane solution was obtained by reacting 17.140g (0.0582 mol) a-BPDA, 26.16g (0.0291 mol) diaminopolysiloxane (450 amino equivalents) and 4.424g (0.0291 mol) diaminobenzoic acid in 54g NMP at 170°C for 3 hours.

### Epoxy reaction

A 17g portion of the above-mentioned polyimidosiloxane solution was taken (0.011 mol of diaminobenzoic acid), 4.51g (0.032 mol) of glycidyl methacrylate in a 3-fold amount with respect to carboxyls was added, and the reaction was conducted at 90°C for 3 hours while circulating dry air. The resulting epoxy-modified solution was blackish brown.

### Mixing

With 25.0g of the epoxy modified solution (12.7g solid portion) there were mixed 3.8g of talc, 2.5g of Aerosil 200, 0.38g of DB-100, 0.97g of Irgacure 369 and 1.95g of Irgacure 184, to obtain a photosensitive polyimidosiloxane solution composition (ink).

### Evaluation of photocuring properties

After forming a film from the photosensitive polyimidosiloxane solution in the same manner as Example 1, it was photocured by irradiation with 1.0 J/cm² ultraviolet light and then immersed in a triglyme solvent, and upon exposure of the uncured portions to ultrasonic waves and washing off of the unexposed portions, floating of the film and surface roughness were observed.

### Example 6

The photosensitive polyimidosiloxane solution (ink) of Example 1 was used for a separate resolving power evaluation according to the following method.

### Test pattern

A glass mask test pattern (positive pattern) was used for the resolving power test. The pattern had a minimum size of 4 µm.

### Film formation

Spin coating was used for the application, with drying at 60°C × 30 minutes, light exposure at 0.21 J/cm² and development in an ultrasonic wave bath (triglyme solvent).

### Evaluation results

A 10 µmΦ hole was formed with a 3 µm film thickness, and no crumbling of the hole was observed.

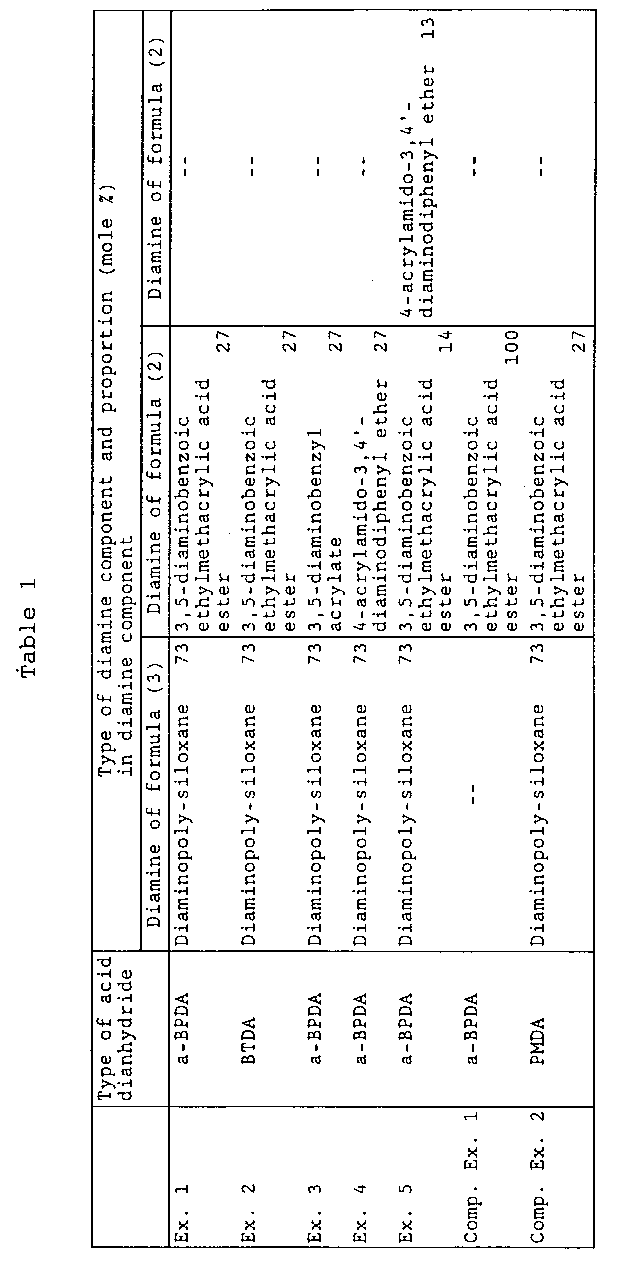

**Table 2**

| | Photosensitive polyimide | | | Cured film | Photocuring properties | | |
|---|---|---|---|---|---|---|---|
| | Inherent viscosity (dℓ/g) | Film formability | Solubility in NMP | Thermal decomposition temperature (°C) | Photosensitivity | | Resolving power (mmΦ) |
| | | | | | Film thickness (µm) | Light irradiation (J/cm²) | |
| Ex. 1 | 0.18 | o | * | 375 | 25 | 0.55 | 0.075 |
| Ex. 2 | 0.15 | o | o | 355 | 23 | 0.50 | 0.075 |
| Ex. 3 | 0.14 | o | * | 380 | 24 | 0.45 | 0.10 |
| Ex. 4 | 0.15 | o | * | 340 | 21 | 0.90 | 0.20 |
| Ex. 5 | 0.14 | o | * | 360 | 25 | 0.85 | 0.15 |
| Comp. Ex. 1 | -- | | x | 410 | -- | -- | -- |
| Comp. Ex. 2 | -- | | △ | 390 | -- | -- | -- |

The photosensitive polyimidosiloxanes of the present invention have excellent solubility, so that the polyimidosiloxanes in the unexposed portions can be easily removed.

Furthermore, the photosensitive polyimidosiloxanes of the invention have high photosensitivity, giving them excellent light transmittance and photocrosslinkability.

Photosensitive polyimidosiloxane solution compositions of the invention may also be formed to large film thicknesses, and with satisfactory photocuring properties of resolving power and photosensitivity.

Cured films formed from the photosensitive polyimidosiloxane solution compositions of the invention also have excellent heat resistance of 300°C and higher, and even 330°C and higher, in terms of the thermal decomposition temperature, as well as soldering heat resistance of 250-300°C, film thicknesses of 2-50 µm, and post-photocuring resolving powers of at least 10 µm, and particularly from 10-1000 µm.

Cured films formed from the photosensitive polyimidosiloxane solution compositions of the invention also have excellent mechanical properties, and electrical properties which are superior to epoxy resins as evaluated based on volume resistance, while also having superb flexibility with no cracks produced upon bending.

## Claims

1. An organic solvent-soluble photosensitive polyimidosiloxane prepared by polymerization and imidation of substantially equimolar amounts of:
an aromatic tetracarboxylic dianhyride component represented by the following general formula (1)
R₁-X-R₂ (1)
wherein R₁ and R₂ each represent mononuclear aromatic residues with acid anhydride groups and X represents CO, O or a direct bond,
and a diamine component consisting of 15-80 mole percent of an aromatic diamine compound containing a photosensitive group, represented by the following general formula (2)
H₂N-R₃-NH₂ (2)
wherein R₃ represents an aromatic residue containing a photosensitive group with an unsaturated hydrocarbon group, and 85-20 mole percent of a diaminopolysiloxane represented by the following general formula (3) 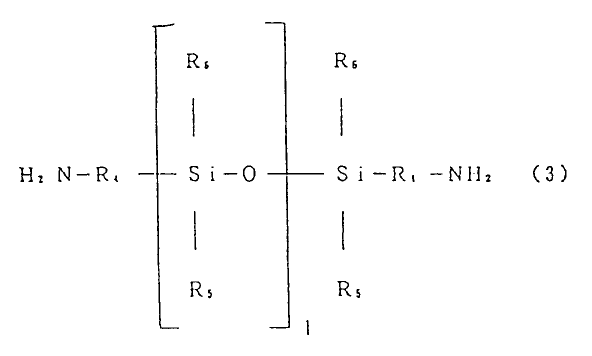 wherein R₄ represents a divalent hydrocarbon residue, R₅ independently represents an alkyl group of 1-3 carbon atoms or a phenyl group, and l represents an integer of 3-30.

2. A photosensitive polyimidosiloxane according to claim 1, wherein the aromatic tetracarboxylic dianhydride is 2,3,3',4'-biphenyltetracarboxylic dianhydride, oxydiphthalic anhydride or benzophenonetetracarboxylic dianhydride.

3. A photosensitive polyimidosiloxane solution composition prepared by dissolving in an organic solvent an organic solvent-soluble photosensitive polyimidosiloxane prepared by polymerization and imidation of substantially equimolar amounts of:
an aromatic tetracarboxylic dianhyride component represented by the following general formula (1)
R₁-X-R₂ (1)
wherein R₁ and R₂ each represent mononuclear aromatic residues with acid anhydride groups and X represents CO, O or a direct bond,
and a diamine component consisting of 15-80 mole percent of an aromatic diamine compound containing a photosensitive group, represented by the following general formula (2)
H₂N-R₃-NH₂ (1)
wherein R₃ represents an aromatic residue containing a photosensitive group with an unsaturated hydrocarbon group, and 85-20 mole percent of a diaminopolysiloxane represented by the following general formula (3) 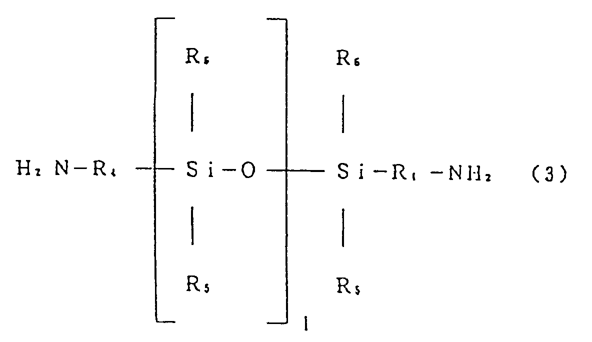 wherein R₄ represents a divalent hydrocarbon residue, R₅ independently represents an alkyl group of 1-3 carbon atoms or a phenyl group, and l represents an integer of 3-30,
wherein the solid concentration consisting of said polyimidosiloxane is 20 to 50 wt%.

4. A photosensitive polyimidosiloxane solution composition according to claim 3, wherein a sensibilizer and photopolymerization initiator are added in a total amount of 1-50 wt% with respect to the photosensitive polyimidosiloxane.

5. A photosensitive polyimidosiloxane solution composition according to claim 3, which further contains at least one member selected from the group consisting of Aerosil, inorganic fillers, polymer fillers and inorganic or organic dyes.

6. An insulating film consisting mainly of polyimidosiloxane as the polymer component, having a thickness of 2-50 µm, and having a resolving power of at least up to 10 µm after photocuring by irradiation with a superhigh-pressure mercury lamp (2 kW) on a dried film prepared from a solution of the photosensitive polyimidosiloxane composition.

7. An insulating film, formed as an insulating film on a board-mounted circuit using a photocured photosensitive polyimidosiloxane solution composition, having a film thickness of 2-50 µm, a resolving power of at least 10 µm, and a soldering heat resistance of 250-300°C.
